# FASCICULE DE BREVET EUROPEEN

(11) **EP 1 589 564 B1**
(45) Date de publication et mention de la délivrance du brevet: **03.01.2007**
(21) Numéro de dépôt: 05290703.7
(22) Date de dépôt: 30.03.2005
(51) Int. Cl.: H01L 21/00

(54) **Enveloppe de transport à protection par effet thermophorèse**
Transportbehälter mit einem thermophoretischen Schutz
Transport box comprising a thermophoresis protection effect

(30) Priorité: 21.04.2004 FR 0450749
(43) Date de publication de la demande: 26.10.2005
(73) Titulaire: ALCATEL, 75008 Paris (FR)
(72) Inventeur: Rival, Jean-Luc, 74370 Villaz (FR); Kambara, Hisanori, 74350 Villy-le-Pelloux (FR); Bernard, Roland, 74540 Viuz-la-Chiesaz (FR)
(74) Mandataire: Chaffraix, Sylvain

(56) Documents cités:
- EP-A- 0 617 573
- US-A1- 2002 124 906
- US-B1- 6 214 425
- US-B2- 6 422 823

## Description

La présente invention concerne la conservation et le déplacement des substrats de semi-conducteurs ou des masques dans les salles blanches, entre les différentes étapes de travail au cours desquelles les substrats de semi-conducteurs ou masques sont utilisés pour les procédés de fabrication de semi-conducteurs et de systèmes mécaniques microélectroniques (MEMS).

Dans la fabrication de semi-conducteurs et de systèmes mécaniques microélectroniques, des plaquettes telles que les plaquettes de silicium ou les masques sont transportées dans des enveloppes de transport ou enceintes de mini-environnement qui les protègent des pollutions qui sont encore présentes dans l'atmosphère des salles blanches.

Actuellement, les piles de plaquettes de silicium de 200 millimètres de diamètre sont transportées dans des enceintes d'interface standardisées (SMIF).

Les piles de plaquettes de silicium de 300 millimètres de diamètre sont transportées dans des enceintes à ouverture frontale standardisées (FOUP).

On a également imaginé des enveloppes de transport ou enceintes de mini-environnement adaptées pour le transport d'une seule plaquette de substrat.

Les plaquettes de semi-conducteur ou autres plaquettes restent typiquement pendant plusieurs semaines dans l'unité de fabrication de semi-conducteurs, entre les diverses étapes des procédés. Au cours de cette durée, les plaquettes de semi-conducteur ou autres plaquettes doivent être protégées contre tout risque de pollution, et c'est la raison pour laquelle on prévoit de les isoler de l'atmosphère intérieure des salles blanches, en les transportant et en les conservant dans les enceintes de mini-environnement.

Dans les applications industrielles actuelles, l'atmosphère intérieure des enceintes de mini-environnement est à pression atmosphérique. Les enceintes sont donc autonomes, sans nécessiter de source d'énergie.

Pour améliorer l'isolement et la protection des plaquettes, on a plus récemment imaginé de générer et maintenir une atmosphère intérieure à basse pression. Or une enceinte de mini-environnement doit être autonome pendant les étapes de déplacement entre les différents postes de travail. Durant cette période d'autonomie, l'enceinte de mini-environnement doit elle-même maintenir l'atmosphère contrôlée autour du substrat qu'elle contient. Cela nécessite une source d'énergie disponible dans l'enceinte de mini-environnement, et un système de pompage pour l'entretien de l'atmosphère contrôlée qui est à très faible pression, pression qui est de l'ordre de celles qui règnent dans les chambres de transfert et de chargement vers les chambres de procédés.

EP0617573 divulgue une enveloppe de transport de plaquettes contenant un élément absorbant pour réduire le taux de contamination.

Que ce soit avec des moyens pour générer et maintenir une atmosphère intérieure à basse pression, ou sans ces moyens de génération et de maintien d'une atmosphère intérieure à basse pression, les enveloppes de transport doivent nécessairement être ouvertes pour l'introduction des masques ou plaquettes de semi-conducteurs, puis pour leur extraction. Pendant les périodes d'ouverture, des particules polluantes peuvent pénétrer dans l'enveloppe de transport, et dégrader ainsi la qualité de l'atmosphère intérieure de l'enveloppe de transport. Lesdites particules risquent ensuite de se déposer sur les masques ou plaquettes de semi-conducteurs contenus dans l'enveloppe de transport.

Une telle pollution est néfaste dans l'industrie du semi-conducteur, car elle crée des défauts qui affectent la qualité du dispositif microélectronique ou micromécanique ainsi réalisé.

Il y a donc un besoin de réduire la pollution des plaquettes de semi-conducteurs ou des masques lors de leur séjour dans les enveloppes de transport.

Le problème proposé par la présente invention est ainsi d'améliorer l'élimination des particules polluantes, en évitant leur dépôt sur la face active du masque ou de la plaquette de semi-conducteur pendant son séjour dans l'enveloppe de transport.

Pour cela, l'idée essentielle de l'invention est de munir l'enveloppe de transport d'un moyen tendant à déplacer les particules polluantes à l'écart de la face active d'un masque ou d'une plaquette de semi-conducteur contenu dans l'enveloppe. L'objet de l'invention est décrit par la revendication 1.

Un tel moyen pour déplacer les particules polluantes peut être avantageusement une plaque refroidie, comportant une face active placée à proximité de la face principale à protéger du masque ou de la plaquette de semi-conducteur. On génère alors un gradient de température entre la plaque refroidie et la face principale à protéger, dès lors que la plaque refroidie est à une température plus basse que celle de la face principale à protéger. Par l'effet de ce gradient de température, les particules polluantes éventuellement présentes dans l'espace entre la plaque refroidie et la face principale à protéger sont progressivement déplacées à l'écart de la face principale à protéger et en direction de la plaque refroidie. Il en résulte une plus faible probabilité de dépôt d'une particule polluante sur la face principale à protéger du masque ou de la plaquette de semi-conducteur.

Le déplacement des particules polluantes s'effectue par l'effet de thermophorèse : les molécules gazeuses environnantes plus chaudes situées entre une particule polluante considérée et la face principale à protéger génèrent sur la particule une poussée plus forte que celle générée par les molécules gazeuses environnantes plus froides situées entre la particule et la plaque refroidie ; la différence des poussées déplace la particule en direction de la plaque refroidie.

L'invention prévoit des moyens pour mettre en oeuvre cet effet de thermophorèse dans une enveloppe de transport adaptée pour le transport de masques ou de plaquettes de semi-conducteur pendant les étapes intermédiaires entre les étapes de procédé de traitement du masque ou de la plaquette de semi-conducteur.

Ainsi, l'invention propose une enveloppe de transport pour masque ou plaquette de semi-conducteur, comprenant une paroi périphérique étanche entourant un espace intérieur conformé pour recevoir et contenir un masque ou une plaquette de semi-conducteur à transporter, avec une porte pour insérer ou extraire le masque ou la plaquette, et avec des moyens supports pour tenir en position fixe le masque ou la plaquette de semi-conducteur par rapport à la paroi périphérique étanche, le masque ou la plaquette de semi-conducteur comportant une face principale à protéger contre les pollutions particulaires ; l'enveloppe de transport comprend :
- une plaque refroidie en matériau conducteur de la chaleur, placée dans l'espace intérieur,
- un générateur de froid, couplé thermiquement à la plaque refroidie par des moyens de couplage thermique, et adapté pour maintenir la plaque refroidie à une température inférieure à la température ambiante dans l'enveloppe de transport,
- des moyens de liaison pour tenir la plaque refroidie en position par rapport à la paroi périphérique étanche,
- des moyens d'isolement thermique, prévus dans les moyens de liaison et adaptés pour isoler thermiquement la plaque refroidie par rapport à la paroi périphérique étanche,
- une source d'énergie embarquée, alimentant le générateur de froid,
- la plaque refroidie ayant une face active positionnée au regard et à proximité de la face principale à protéger.

Cette disposition permet de bénéficier de l'effet de thermophorèse pour réduire la pollution de la face principale à protéger, tout en restant compatible avec les autres fonctionnalités de l'enveloppe de transport, et notamment la nécessité d'un maintien satisfaisant du masque ou de la plaquette de semi-conducteur dans l'enveloppe de transport, la nécessité d'une mobilité aisée du masque ou de la plaquette de semi-conducteur pour son introduction dans l'enveloppe de transport ou son extraction hors de l'enveloppe de transport, et l'autonomie de l'enveloppe de transport pour permettre son utilisation comme moyen de transport et de stockage de masques ou de plaquettes de semi-conducteur dans les installations de fabrication de semi-conducteurs.

Selon un mode de réalisation préféré, la face active de la plaque refroidie est plane et de dimensions supérieures à celles de la face principale à protéger.

Egalement, de façon préférée, la face active de la plaque refroidie est sensiblement parallèle à la face principale à protéger. On répartit ainsi équitablement l'effet de thermophorèse sur toute la face principale à protéger.

L'effet de thermophorèse est efficace lorsque le gradient de température est assez élevé entre la plaque refroidie et la face principale à protéger. Pour cela, un premier moyen est constitué par le générateur de froid et les moyens de couplage thermique, qui refroidissent la plaque refroidie, avec les moyens d'isolement thermique qui isolent thermiquement la plaque refroidie par rapport à la paroi périphérique étanche, évitant le refroidissement de ladite paroi périphérique étanche. Un autre moyen est d'éviter le refroidissement du masque ou de la plaquette de semi-conducteur pendant son séjour dans l'enveloppe de transport, en prévoyant que les moyens supports sont conducteurs de la chaleur, maintenant ainsi le masque ou la plaquette de semi-conducteur à la température ambiante, c'est-à-dire à la température de la paroi périphérique étanche.

On obtiendra de bons résultats en prévoyant que le générateur de froid maintient un gradient de température de 3 à 10°C environ entre la plaque refroidie et la face principale à protéger.

La face active de la plaque refroidie peut avantageusement être à une distance déterminée faible de la face principale à protéger. Cette distance déterminée peut avantageusement être inférieure à 1 cm, et encore plus avantageusement égale à 5 mm environ.

Du fait de l'attraction des particules polluantes, la plaque refroidie se charge progressivement de particules polluantes. Un risque existe donc de voir ultérieurement certaines particules polluantes se détacher de la plaque refroidie pour venir se poser sur la face principale à protéger. Il est donc utile de nettoyer périodiquement la plaque refroidie. On prévoit pour cela que la plaque refroidie est démontable, de sorte que son nettoyage périodique peut se faire à l'écart de l'enveloppe de transport.

En principe, tant que la plaque refroidie est à une température suffisamment basse, on peut espérer que les particules qui ont été attirées par la plaque refroidie vont rester sur ou à proximité immédiate de la plaque refroidie pendant un temps suffisant, c'est-à-dire pendant le temps de stockage et de transport de la plaquette de semi-conducteur ou du masque.

Mais un risque subsiste que les particules se détachent de la plaque refroidie. En fait, lorsque les particules viennent en contact de la plaque refroidie, elles peuvent rebondir, glisser tangentiellement, ou adhérer à la plaque refroidie. Il paraît donc avantageux de faire en sorte que les particules adhèrent à la plaque refroidie pendant un temps suffisant jusqu'au traitement ultérieur de nettoyage.

La capacité d'adhésion des particules sur la plaque refroidie peut dépendre de plusieurs paramètres physiques. En particulier, cette capacité peut dépendre du matériau constituant la plaque refroidie, de son état de surface, et de sa température.

Selon l'invention, on pourra donc avantageusement faire en sorte que la face active de la plaque refroidie ait une constitution qui lui confère des propriétés de piège à particules, pour retenir les particules incidentes, c'est-à-dire les particules qui se sont approchées suffisamment de la plaque refroidie ou qui sont entrées en contact avec elle.

Selon un premier mode de réalisation, la plaque refroidie peut être en un matériau qui présente en lui-même des propriétés de piège à particules par adhésion des particules incidentes.

Selon un autre mode de réalisation, en alternative ou en complément, la plaque refroidie peut avoir reçu, sur sa face active, un traitement de surface approprié lui conférant des propriétés de piège à particules. Le traitement peut par exemple augmenter la rugosité de la surface. On notera toutefois qu'une rugosité de surface peut également augmenter le phénomène indésirable de dégazage dans un environnement de vide.

En alternative ou en complément, la face active de la plaque refroidie peut être constituée par la face externe d'une mince couche de surface en un matériau approprié qui est appliqué sur la plaque refroidie. On peut imaginer par exemple le dépôt d'une mince couche métallique appropriée.

Une réduction de la pollution éventuelle des masques ou plaquettes de semi-conducteur dans l'enveloppe de transport peut encore être obtenue en prévoyant en outre des moyens de pompe pour générer et entretenir dans l'enveloppe de transport un vide de 50 à 1 000 Pascals.

Pour résoudre le problème de l'autonomie et des faibles dimensions des enceintes de mini-environnement, il convient d'utiliser un système de pompage embarqué sur l'enceinte de mini-environnement, avec également une source d'énergie embarquée. L'enceinte de mini-environnement étant étanche, la capacité de pompage peut être faible, juste suffisante pour maintenir le vide approprié pendant la durée d'autonomie désirée. On peut ainsi envisager d'utiliser des moyens de pompe comprenant une micropompe ayant une pluralité de cellules élémentaires à transpiration thermique, qui fonctionnent de façon satisfaisante lorsque la pression des gaz est basse. Une telle micropompe peut être associée à une pompe primaire connectée en série au refoulement de la micropompe, et refoulant elle-même à l'atmosphère. Cela nécessite une source d'énergie de capacité suffisante pour alimenter non seulement la micropompe mais également la pompe primaire.

Une telle micropompe peut avantageusement comprendre une pluralité de cellules élémentaires de pompage à transpiration thermique. De telles cellules de pompage à transpiration thermique utilisent l'effet de transpiration thermique mis en évidence par Knudsen dans les années 1900, effet selon lequel, lorsque deux volumes successifs sont reliés par un canal de dimensions transversales très faibles, dont le rayon est inférieur au libre parcours moyen des molécules gazeuses présentes, et lorsque les extrémités du canal sont à des températures différentes, une différence de pression s'établit entre les deux volumes successifs. Dans le canal de petite dimension, les molécules se déplacent selon un régime moléculaire, et il en résulte que les pressions diffèrent aux deux extrémités du canal par suite de la différence des températures. En régime moléculaire, lorsque l'équilibre thermique est atteint, les pressions aux deux extrémités du canal sont telles que leur rapport est égal à la racine carrée du rapport des températures correspondantes. Lorsque les molécules atteignent le volume adjacent à l'extrémité du canal, leur déplacement suit alors le régime d'un milieu visqueux, et elles ne peuvent pas retourner dans le canal. Cela produit un effet de pompage.

Le taux de compression d'une cellule élémentaire est faible, mais il est possible de multiplier le nombre de cellules connectées aérauliquement en série et/ou en parallèle, afin d'atteindre le taux de compression approprié et la capacité de pompage appropriée.

Une telle enceinte de mini-environnement est ainsi adaptée pour présenter une autonomie satisfaisante, grâce à la faible consommation de la micropompe.

Dans ce cas, le générateur de froid peut avantageusement comprendre une ou plusieurs sources froides d'éléments Peltier dont la ou les sources chaudes constituent les éléments chauffants de cellules élémentaires de pompage à transpiration thermique formant des moyens de pompe pour générer et entretenir un vide approprié dans l'enveloppe.

On réalise ainsi une certaine économie d'énergie, par le fait que l'énergie électrique distribuée par la source d'énergie embarquée dans l'enveloppe de transport est entièrement transformée en énergie de refroidissement pour la plaque refroidie et en énergie d'échauffement pour la micropompe.

En complément ou en alternative, on peut prévoir un élément adsorbant placé au contact de l'atmosphère de la cavité intérieure de l'enceinte de mini-environnement. L'élément adsorbant permet alors d'adsorber les molécules gazeuses, en participant ainsi au maintien du vide dans la cavité intérieure, en complément de la micropompe, ou à la place de la micropompe.

D'autres objets, caractéristiques et avantages de la présente invention ressortiront de la description suivante de modes de réalisation particuliers, faite en relation avec les figures jointes, parmi lesquelles :
- la figure 1 est une vue schématique de côté en coupe d'une enveloppe de transport selon un mode de réalisation de l'invention, contenant un masque ou plaquette de semi-conducteur avec la face principale à protéger orientée vers le haut ;
- la figure 2 illustre une variante de l'enveloppe de transport de la figure 1, contenant un masque ou plaquette de semi-conducteur avec la face principale à protéger orientée vers le bas ;
- la figure 3 illustre un autre mode de réalisation de l'enveloppe de transport de la figure 1, incluant une couche de surface ; et
- la figure 4 est une variante de l'enveloppe de transport de la figure 3, avec la face principale à protéger orientée vers le bas.

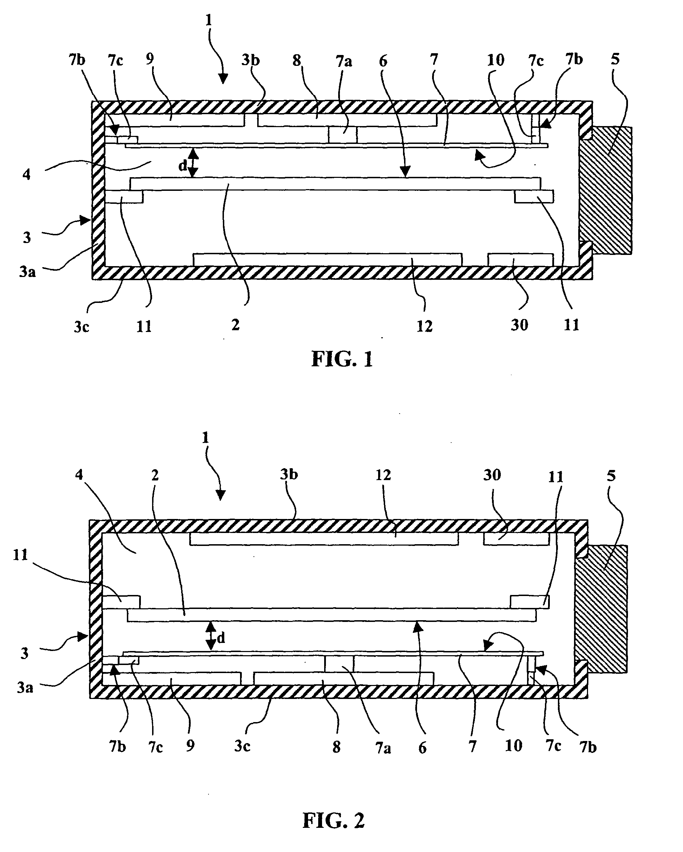

Dans le mode de réalisation illustré sur la figure 1, une enveloppe de transport 1 selon l'invention comprend une cavité intérieure 4 conformée pour recevoir et contenir une plaquette 2, telle qu'une plaquette de semi-conducteur, ou un masque, utilisés dans l'industrie des semi-conducteurs.

La dimension de la cavité intérieure 4 est choisie en fonction de la taille de la plaquette 2 à contenir, et on prévoit, de préférence, que les dimensions de la cavité intérieure 4 sont seulement peu supérieures aux dimensions de la plaquette 2, de façon à ne laisser autour de la plaquette 2 qu'une atmosphère à volume relativement réduit, plus facile à maintenir dans un état satisfaisant pendant une longue période d'autonomie.

La cavité intérieure 4 présente avantageusement une forme à portion cylindrique, adaptée pour contenir une plaquette de semi-conducteur 2 en forme de disque.

La cavité intérieure 4 est entourée d'une paroi périphérique étanche 3, comprenant une partie périphérique 3a, une première partie principale 3b, et une seconde partie principale 3c.

La partie périphérique 3a de la paroi périphérique étanche 3 comprend une structure d'ouverture latérale obturable 5, permettant d'insérer ou d'extraire le masque ou la plaquette 2. La structure d'ouverture latérale obturable 5 est conformée, de façon connue, pour coopérer avec des moyens externes d'ouverture et de fermeture automatique, et avec des moyens de manipulation du masque ou de la plaquette de semi-conducteur 2 pour son introduction ou son extraction.

Le masque ou la plaquette de semi-conducteur 2 présente en principe une face principale 6 qu'il convient de protéger plus spécialement contre les pollutions particulaires. Il s'agit de la face sur laquelle sont gravés les motifs qui définissent la géométrie des composants semi-conducteurs.

Le masque ou la plaquette de semi-conducteur 2 est maintenu en position fixe dans l'espace intérieure 4 par des moyens supports 11, par exemple les moyens supports connus en soi et généralement utilisés dans les enveloppes de transport pour masques ou plaquettes de semi-conducteurs, qui ne sont donc que schématiquement illustrés sur les figures. Ainsi, les moyens supports 11 sont interposés entre la paroi périphérique étanche 3 et le masque ou la plaquette de semi-conducteur 2. Comme moyens supports 11, on pourra préférer un dispositif de serrage électrostatique.

De préférence, ces moyens supports 11 sont conducteurs de la chaleur, et maintiennent ainsi le masque ou la plaquette de semi-conducteur 2 à la température ambiante ou température de la paroi périphérique étanche 3.

Une plaque refroidie 7, en matériau conducteur de la chaleur, est placée dans l'espace intérieur 4 face à la face principale 6 à protéger.

La plaque refroidie 7 est tenue par des moyens de liaison 7b en position fixe dans l'espace intérieur 4, les moyens de liaison 7b assurant la liaison mécanique entre la plaque refroidie 7 et la paroi périphérique étanche 3. Des moyens d'isolement thermique 7c sont prévus dans les moyens de liaison 7b, et sont adaptés pour isoler thermiquement la plaque refroidie 7 par rapport à la paroi périphérique étanche 3.

Un générateur de froid 8, schématiquement illustré, est couplé thermiquement à la plaque refroidie 7 par des moyens de couplage thermique 7a. Le générateur de froid 8 maintient la plaque refroidie 7 à une température inférieure à la température ambiante dans l'enveloppe de transport 1.

Une source d'énergie embarquée 9 alimente le générateur de froid 8 pour lui conférer l'énergie nécessaire à la génération du froid.

La plaque refroidie 7 comporte une face active 10 positionnée au regard et à proximité de la face principale à protéger 6. De la sorte, un gradient thermique est réalisé entre la plaque refroidie 7 et le masque ou la plaquette de semi-conducteur 2. Ce gradient peut avantageusement être de 3 à 10°C environ.

La face active 10 de la plaque refroidie 7 peut avantageusement être plane et de dimensions supérieures à celles de la face principale à protéger 6. De même, la face active 10, dans le mode de réalisation illustré sur les figures, est sensiblement parallèle à la face principale à protéger 6.

Enfin, la face active 10 de la plaque refroidie 7 est à une distance déterminée d de la face principale à protéger 6. Cette distance déterminée d doit être faible, de préférence inférieure à 1 cm. De bons résultats peuvent être obtenus en utilisant une distance déterminée d égale à 5 mm environ.

La plaque refroidie 7 peut être en tout matériau ayant une grande conductivité thermique. On peut par exemple utiliser le silicium, ou l'aluminium. Les métaux pourront également être choisis pour leurs propriétés favorables dans le vide, en particulier pour le fait qu'ils présentent une faible propension au dégazage, et une capacité de réduire les risques d'apparition de champs électriques, champs électriques qui sont ensuite susceptibles de provoquer le déplacement indésirable de certaines particules polluantes.

Le gradient de température entre la plaque refroidie 7 et le masque ou plaquette de semi-conducteur 2 qui se trouve à température plus élevée que la plaque refroidie 7, induit, par effet de thermophorèse, une force de poussée des particules en direction de la plaque refroidie 7, et donc à l'écart du masque ou de la plaquette de semi-conducteur 2. Cette force de poussée est capable de s'opposer aux diverses forces susceptibles de provoquer le déplacement des particules polluantes vers le masque ou plaquette de semi-conducteur 2, par exemple des forces électrostatiques, la force de gravité, les mouvements Browniens. Les forces de thermophorèse provoquent le déplacement des particules vers les régions à plus basse température.

On sait que l'effet de thermophorèse diminue lorsque la pression gazeuse diminue dans l'espace intérieur 4. L'expérience a toutefois montré que l'effet de thermophorèse est encore très efficace dans les plages de pression généralement utilisées dans les enveloppes de transport de masque ou plaquette de semi-conducteur. On considère ainsi qu'avec un gradient de température d'environ 10°, pour une distance d d'environ 1 cm, et pour une pression gazeuse d'environ 5 Pascals, on obtient une réduction de dépôt de particules sur la face principale à protéger 6 selon un facteur d'environ 10⁶ en ce qui concerne les particules ayant un diamètre supérieur à 0,03 microns.

De préférence, la plaque refroidie 7 est montée de façon amovible dans l'enveloppe de transport, de façon à être retirée temporairement de l'enveloppe de transport ou changée contre une autre plaque refroidie. Le retrait doit pouvoir se faire à travers la structure d'ouverture latérale obturable 5. Cela permet la régénération de la plaque refroidie 7 ou son nettoyage périodique à l'écart de l'enveloppe de transport 1, par exemple par balayage d'azote et/ou par chauffage.

Dans la réalisation illustrée sur la figure 1, la face principale 6 à protéger est orientée vers le haut. Dans ce cas, la plaque refroidie 7 forme le plafond de l'espace intérieur 4. On comprend que cette disposition peut favoriser un certain dépôt de particules polluantes qui se déplacent par gravité en direction de la face principale 6 à protéger. L'action de la gravité est toutefois limitée.

Dans la seconde réalisation, illustrée sur la figure 2, la face principale 6 à protéger contre les pollutions particulaires est orientée vers le bas. La plaque refroidie 7 forme alors le plancher de l'espace intérieur 4. On comprend que cette disposition est plus favorable, en ce sens que la gravité naturelle est utilisée comme moyen supplémentaire tendant à réduire la probabilité de dépôt des particules polluantes sur la face principale 6 à protéger.

Dans les modes de réalisation illustrés sur les figures, on a prévu en outre des moyens de pompe 12 pour générer et entretenir dans l'enveloppe de transport 1 un vide approprié, par exemple un vide de 50 à 1 000 Pascals environ.

Les moyens de pompe 12 peuvent avantageusement comprendre une micropompe à transpiration thermique, constituée d'une pluralité de cellules de pompage élémentaires dont certaines sont connectées en série, plusieurs sous-ensembles série pouvant être connectés en parallèle, afin d'obtenir les propriétés désirées de débit et de taux de compression pour l'application envisagée.

Les cellules élémentaires de pompage par transpiration thermique comportent une source chaude pouvant être une résistance électrique, qui est alors alimentée en énergie électrique pour produire l'effet de compression. On prévoit alors une réserve d'énergie telle que des moyens accumulateurs d'énergie électrique, par exemple un accumulateur électrique rechargeable. La réserve d'énergie peut être constituée par la source d'énergie embarquée 9 précédemment mentionnée, ou par une réserve d'énergie distincte.

Les moyens de pompe 12 peuvent, en alternative ou en complément, comprendre un élément adsorbant 30 susceptible d'adsorber les molécules gazeuses et de favoriser ainsi le maintien d'une pression basse dans l'espace intérieur 4.

Un exemple de matériau possible pour réaliser l'élément adsorbant 30 est constitué par des zéolithes. Les zéolithes sont des silico-aluminate alcalins cristallisés en structure stable, présentant une microporosité régulière et importante dans laquelle les cations sont aussi mobiles que dans un liquide. Il en résulte une capacité d'échange, d'adsorption et de catalyse. Les zéolithes constituent une structure solide définissant de grandes cavités internes dans lesquelles les molécules peuvent être adsorbées. Ces cavités sont interconnectées par des ouvertures de pores à travers lesquels les molécules peuvent passer. Grâce à la nature cristalline, les pores et les cavités ont des tailles régulières et très voisines, et, en fonction de la taille des ouvertures, la structure peut adsorber certaines molécules correspondant à la taille des ouvertures, alors que d'autres molécules plus grosses sont rejetées. On choisira donc les zéolithes appropriées en fonction de la taille des molécules gazeuses à adsorber.

En alternative, comme élément adsorbant, on peut utiliser tous autres matériaux qui constituent habituellement des pompes à sorbeur ou pompe getter.

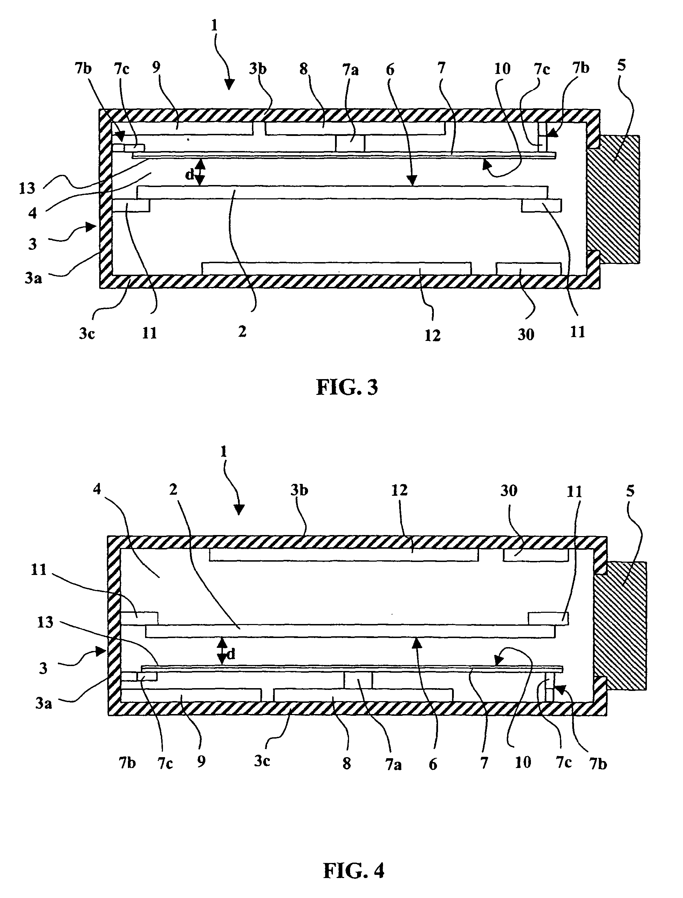

Les modes de réalisation des figures 3 et 4 reprennent la plupart des moyens essentiels des modes de réalisation des figures 1 et 2. Ces moyens essentiels sont repérés par les mêmes références numériques, et ne seront donc pas décrits à nouveau.

Les modes de réalisation des figures 3 et 4 se distinguent par le fait que l'on prévoit en outre des moyens de piège à particules 13, selon la face active 10 de la plaque refroidie 7.

Les moyens de piège à particules doivent retenir les particules incidentes qui ont préalablement été déplacées jusqu'à venir en contact ou à proximité immédiate de la plaque refroidie.

Selon une première possibilité, la plaque refroidie peut être constituée en un matériau qui présente en lui-même des propriétés de piège à particules par adhésion des particules incidentes. Des matériaux tels que l'aluminium, le cuivre, le silicium présentent de bonnes propriétés à cet égard.

Selon une seconde possibilité, utilisée en alternative ou en complément, la plaque refroidie peut recevoir, sur sa face active, un traitement de surface approprié lui conférant des propriétés améliorées de piège à particules. Par exemple, une augmentation de rugosité de surface, par un tel traitement de surface, peut augmenter la capacité de retenue de particules. Il faudra toutefois éviter d'augmenter de façon inconsidérée les phénomènes de dégazage que présentent habituellement les surfaces rugueuses. On pourra donc préférer d'autres types de traitement de surface compatibles avec une atmosphère à faible pression.

Selon une autre possibilité, la face active de la plaque refroidie peut être la face externe d'une mince couche de surface en un matériau approprié, appliquée sur la plaque refroidie. La couche de surface peut être appliquée par tous moyens, par exemple par collage, ou par soudure. La mince couche peut être un placage métallique, qui est compatible avec une atmosphère à faible pression.

Les matériaux appropriés pour réaliser les propriétés de piège à particules par adhésion des particules incidentes peuvent être avantageusement choisis parmi les matériaux présentant une grande activité électronique. Le cuivre, l'aluminium, le silicium présentent de telles propriétés. Dans les applications de traitement de plaquettes de silicium pour la fabrication de composants électroniques, une surface active en silicium peut présenter l'intérêt d'éviter tous risques de contamination par apport d'une matière étrangère à celle de la plaquette à traiter.

Les particules qui sont poussées par effet thermophorèse vers la plaque refroidie 7 viennent en contact sur et adhèrent à la couche 13. De la sorte, on évite le déplacement ultérieur des particules.

La couche superficielle 13 est mince, pour éviter de dégrader l'effet thermophorèse.

On comprend que les moyens décrits ci-dessus, dans tous les modes de réalisation des figures 1 à 4 selon l'invention, permettent à la fois d'améliorer la protection de la face principale 6 à protéger contre les pollutions particulaires, et de garantir une autonomie satisfaisante de l'enveloppe de transport, grâce à une dépense d'énergie réduite pour alimenter les moyens de thermophorèse et les moyens de pompage.

La présente invention n'est pas limitée aux modes de réalisation qui ont été explicitement décrits, mais elle en inclut les diverses variantes et généralisations qui sont à la portée de l'homme du métier.

## Revendications

1. - Enveloppe de transport (1) pour masque ou plaquette de semi-conducteur (2), comprenant une paroi périphérique étanche (3) entourant un espace intérieur (4) conformé pour recevoir et contenir un masque ou une plaquette de semi-conducteur (2) à transporter, avec une porte (5) pour insérer ou extraire le masque ou la plaquette (2), et avec des moyens supports (11) pour tenir en position fixe le masque ou la plaquette de semi-conducteur (2) par rapport à la paroi périphérique étanche (3), le masque ou la plaquette de semi-conducteur (2) comportant une face principale (6) à protéger contre les pollutions particulaires, **caractérisée en ce que** l'enveloppe de transport (1) comprend :
- une plaque refroidie (7) en matériau conducteur de la chaleur, placée dans l'espace intérieur (4),
- un générateur de froid (8), couplé thermiquement à la plaque refroidie (7) par des moyens de couplage thermique (7a), et adapté pour maintenir la plaque refroidie (7) à une température inférieure à la température ambiante dans l'enveloppe de transport (1),
- des moyens de liaison (7b) pour tenir la plaque refroidie (7) en position par rapport à la paroi périphérique étanche (3),
- des moyens d'isolement thermique (7c), prévus dans les moyens de liaison (7b) et adaptés pour isoler thermiquement la plaque refroidie (7) par rapport à la paroi périphérique étanche (3),
- une source d'énergie embarquée (9), alimentant le générateur de froid (8),
- la plaque refroidie (7) ayant une face active (10) positionnée au regard et à proximité de la face principale à protéger (6).

2. - Enveloppe de transport selon la revendication 1, **caractérisée en ce que** la face active (10) de la plaque refroidie (7) est plane et de dimensions supérieures à celles de la face principale à protéger (6).

3. - Enveloppe de transport selon la revendication 2, **caractérisée en ce que** la face active (10) de la plaque refroidie (7) est sensiblement parallèle à la face principale à protéger (6).

4. - Enveloppe de transport selon l'une quelconque des revendications 1 à 3, **caractérisée en ce que** la face active (10) de la plaque refroidie (7) est à une distance déterminée (d) faible de la face principale à protéger (6), ladite distance déterminée (d) étant inférieure à 1 centimètre, avantageusement égale à 5 mm environ.

5. - Enveloppe de transport selon l'une quelconque des revendications 1 à 4, **caractérisée en ce que** les moyens supports (11) sont conducteurs de la chaleur, pour maintenir le masque ou la plaquette de semi-conducteur (2) à la température ambiante.

6. - Enveloppe de transport selon l'une quelconque des revendications 1 à 5, **caractérisée en ce que** le générateur de froid (8) maintient un gradient de température de 3 à 10°C environ entre la plaque refroidie (7) et la face principale à protéger (6).

7. - Enveloppe de transport selon l'une quelconque des revendications 1 à 6, **caractérisée en ce que** la plaque refroidie (7) est démontable pour permettre son nettoyage périodique à l'écart de l'enveloppe de transport (1).

8. - Enveloppe de transport selon l'une quelconque des revendications 1 à 7, **caractérisée en ce qu**'elle comprend des moyens de pompe (12) pour générer et entretenir dans l'enveloppe de transport (1) un vide de 50 à 1 000 Pascals environ.

9. - Enveloppe de transport selon la revendication 8, **caractérisée en ce que** les moyens de pompe (12) comprennent une pluralité de cellules élémentaires de pompage à transpiration thermique.

10. - Enveloppe de transport selon l'une quelconque des revendications 1 à 9, **caractérisée en ce que** le générateur de froid (8) comprend une ou plusieurs sources froides d'éléments Peltier.

11. - Enveloppe de transport selon l'une quelconque des revendications 1 à 10, **caractérisée en ce qu**'on prévoit des moyens de piège à particules (13) selon la face active (10) de la plaque refroidie (7).

12. - Enveloppe de transport selon la revendication 11, **caractérisée en ce que** la plaque refroidie (7) est en un matériau qui présente en lui-même des propriétés de piège à particules par adhésion des particules incidentes.

13. - Enveloppe de transport selon l'une des revendications 11 ou 12, **caractérisée en ce que** la plaque refroidie (7) a reçu, sur sa face active (10), un traitement de surface approprié lui conférant les propriétés de piège à particules.

14. - Enveloppe de transport selon l'une quelconque des revendications 11 à 13, **caractérisée en ce que** la face active (10) de la plaque refroidie (7) est la face externe d'une mince couche de surface (13) en un matériau approprié appliqué sur la plaque refroidie (7).

## Claims

1. A transport pod (1) for a mask or a semiconductor wafer (2), the pod comprising a leakproof peripheral wall (3) surrounding an inside space (4) shaped to receive and contain a mask or a semiconductor wafer (2) that is to be transported, the wall having a port (5) for inserting or extracting the mask or the wafer (2), and having support means (11) for holding the mask or the semiconductor wafer (2) in a fixed position relative to the leakproof peripheral wall (3), the mask or the semiconductor wafer (2) having a main face (6) that is to be protected against particulate pollution, the transport pod (1) being **characterized in that** it comprises:
· a cold plate (7) of thermally conductive material placed in the inside space (4);
· a cold source (8) thermally coupled to the cold plate (7) by thermal coupling means (7a) and adapted to maintain the cold plate (7) at a temperature lower than the ambient temperature in the transport pod (1);
· connection means (7b) for holding the cold plate (7) in position relative to the leakproof peripheral wall (3);
thermal insulation means (7c) provided in the connection means (7b) and adapted to insulate the cold plate (7) thermally relative to the leakproof peripheral wall (3);
· an on-board energy source (9) powering the cold source (8); and
· the cold plate (7) having an active face (10) positioned facing the main face (6) that is to be protected and in the vicinity thereof.

2. A transport pod according to claim 1, **characterized in that** the active face (10) of the cold plate (7) is plane and of dimensions greater than the dimensions of the main face (6) that is to be protected.

3. A transport pod according to claim 2, **characterized in that** the active face (10) of the cold plate (7) is substantially parallel to the main face (6) that is to be protected.

4. A transport pod according to any one of claims 1 to 3, **characterized in that** the active face (10) of the cold plate (7) is at a determined small distance (d) from the main face (6) that is to be protected, said determined distance (d) being less than 1 cm, and advantageously being equal to about 5 mm.

5. A transport pod according to any one of claims 1 to 4, **characterized in that** the support means (11) are thermally conductive for maintaining the mask or the semiconductor wafer (2) at ambient temperature.

6. A transport pod according to any one of claims 1 to 5, **characterized in that** the cold source (8) maintains a temperature gradient of about 3°C to 10°C between the cold plate (7) and the main face (6) that is to be protected.

7. A transport pod according to any one of claims 1 to 6, **characterized in that** the cold plate (7) is movable to enable it to be cleaned periodically away from the transport pod (1).

8. A transport pod according to any one of claims 1 to 7, **characterized in that** it includes pump means (12) for generating and maintaining a vacuum of about 50 Pa to 1000 Pa inside the transport pod (1).

9. A transport pod according to claim 8, **characterized in that** the pump means (12) comprise a plurality of individual thermal transpiration pumping cells.

10. A transport pod according to any one of claims 1 to 9, **characterized in that** the cold source (8) comprises one or more Peltier element cold sources.

11. A transport pod according to any one of claims 1 to 10, **characterized in that** particle-trapping means (13) are provided on the active face (10) of the cold plate (7).

12. A transport pod according to claim 11, **characterized in that** the cold plate (7) is made of a material that itself presents particle-trapping properties by incident particles adhering thereto.

13. A transport pod according to claim 11 or claim 12, **characterized in that** the active face (10) of the cold plate (7) has received surface treatment suitable for giving it particle-trapping properties.

14. A transport pod according to any one of claims 11 to 13, **characterized in that** the active face (10) of the cold plate (7) is the outside face of a thin surface layer (13) of a suitable material applied to the cold plate (7).

## Patentansprüche

1. - Transportbehälter (1) für eine Maske oder einen Halbleiterwafer (2), umfassend eine dichte Außenwand (3), welche einen Innenraum (4) umgibt, der so geformt ist, dass er eine zu transportierende Maske oder einen Halbleiterwafer (2) aufnehmen und enthalten kann, mit einer Tür (5), um die Maske oder den Wafer (2) einzulegen oder zu entnehmen, und mit Halterungsvorrichtungen (11), um die Maske oder den Halbleiterwafer (2) gegenüber der dichten Außenwand (3) in einer festen Position zu halten, wobei die Maske oder der Halbleiterwafer (2) eine vor Verunreinigungen durch Partikel zu schützende Hauptfläche (6) umfasst, **dadurch gekennzeichnet, dass** der Transportbehälter (1) umfasst:
- eine gekühlte Platte (7) aus einem wärmeleitenden Werkstoff, angeordnet im Innenraum (4);
- einen Kältegenerator (8), der durch thermische Kopplungsmittel (7a) thermisch mit der gekühlten Platte (7) gekoppelt ist und der geeignet ist, die gekühlte Platte (7) auf einer Temperatur unter der Umgebungstemperatur im Transportbehälter (1) zu halten;
- Verbindungsvorrichtungen (7b), um die gekühlte Platte (7) gegenüber der dichten Außenwand (3) in der korrekten Position zu halten;
- Wärmeisolierungsvorrichtungen (7c), die in den Verbindungsvorrichtungen (7b) vorgesehen und dafür geeignet sind, die gekühlte Platte (7) gegenüber der dichten Außenwand (3) thermisch zu isolieren;
- eine integrierte Energiequelle (9), die den Kältegenerator (8) speist;
- hierbei weist die gekühlte Platte (7) eine aktive Fläche (10) auf, die gegenüber der und in der Nähe der zu schützenden Hauptfläche (6) angeordnet ist.

2. - Transportbehälter nach Anspruch 1, **dadurch gekennzeichnet, dass** die aktive Fläche (10) der gekühlten Platte (7) eben und von größeren Abmessungen ist als diejenigen der zu schützenden Hauptfläche (6).

3. - Transportbehälter nach Anspruch 2, **dadurch gekennzeichnet, dass** die aktive Fläche (10) der gekühlten Platte (7) vorzugsweise im Wesentlichen parallel zu der zu schützenden Hauptfläche (6) angeordnet ist.

4. - Transportbehälter nach einem beliebigen der Ansprüche 1 bis 3, **dadurch gekennzeichnet, dass** die aktive Fläche (10) der gekühlten Platte (7) in einem festgelegten geringen Abstand (d) von der zu schützenden Hauptfläche (6) angeordnet ist, wobei dieser festgelegte Abstand d kleiner als 1 cm ist und vorteilhafterweise ungefähr gleich 5 mm ist.

5. - Transportbehälter nach einem beliebigen der Ansprüche 1 bis 4, **dadurch gekennzeichnet, dass** die Halterungsvorrichtungen (11) wärmeleitend sind, um die Maske oder den Halbleiterwafer (2) auf Umgebungstemperatur zu halten.

6. - Transportbehälter nach einem beliebigen der Ansprüche 1 bis 5, **dadurch gekennzeichnet, dass** der Kältegenerator (8) einen Temperaturgradienten von ungefähr 3° bis 10° zwischen der gekühlten Platte (7) und der zu schützenden Hauptfläche (6) aufrechterhält.

7. - Transportbehälter nach einem beliebigen der Ansprüche 1 bis 6, **dadurch gekennzeichnet, dass** die gekühlte Platte (7) ausbaubar ist, um ihre regelmäßige Reinigung außerhalb des Transportbehälters (1) zu ermöglichen.

8. - Transportbehälter nach einem beliebigen der Ansprüche 1 bis 7, **dadurch gekennzeichnet, dass** er Pumpvorrichtungen (12) umfasst, um in dem Transportbehälter (1) ein Vakuum von ungefähr 50 bis 1.000 Pascal zu erzeugen und aufrechtzuerhalten.

9. - Transportbehälter nach Anspruch 8, **dadurch gekennzeichnet, dass** die Pumpvorrichtungen (12) eine Vielzahl von mit thermischer Transpiration arbeitenden Elementarpumpzellen umfassen.

10. - Transportbehälter nach einem beliebigen der Ansprüche 1 bis 9, **dadurch gekennzeichnet, dass** der Kältegenerator (8) eine oder mehrere Kältequellen aus Peltier-Elementen umfasst.

11. - Transportbehälter nach einem beliebigen der Ansprüche 1 bis 10, **dadurch gekennzeichnet, dass** Partikelfallenvorrichtungen (13) entsprechend der aktiven Fläche (10) der gekühlten Platte (7) vorgesehen sind.

12. - Transportbehälter nach Anspruch 11, **dadurch gekennzeichnet, dass** die gekühlte Platte (7) aus einem Werkstoff besteht, der von sich aus Eigenschaften einer Partikelfalle durch Adhäsion einfallender Partikel aufweist.

13. - Transportbehälter nach einem der Ansprüche 11 oder 12, **dadurch gekennzeichnet, dass** die gekühlte Platte (7) auf ihrer aktiven Fläche (10) eine geeignete Oberflächenbehandlung erhalten hat, die ihr Eigenschaften einer Partikelfalle verleiht.

14. - Transportbehälter nach einem beliebigen der Ansprüche 11 bis 13, **dadurch gekennzeichnet, dass** die aktive Fläche (10) der gekühlten Platte (7) die Außenseite einer dünnen Oberflächenschicht (13) aus einem geeigneten Werkstoff ist, der auf die gekühlte Platte (7) aufgebracht wird.
